# FASCICULE DE BREVET EUROPEEN

(11) **EP 4 391 348 B1**
(45) Date de publication et mention de la délivrance du brevet: **29.10.2025**
(21) Numéro de dépôt: 22216418.8
(22) Date de dépôt: 23.12.2022
(51) Int. Cl.: H02N 2/00, H02N 2/10, G04C 3/12

(54) **RÉSONATEUR PIÉZOÉLECTRIQUE À DOUBLE PIVOT RCC, NOTAMMENT POUR MOTEUR ROTATIF D'HORLOGERIE**
PIEZOELEKTRISCHER RESONATOR MIT DOPPELTEM RCC-SCHWENKPUNKT, INSBESONDERE FÜR ROTATIONSMOTOREN VON UHRWERKEN
PIEZOELECTRIC RESONATOR WITH DOUBLE RCC PIVOT, IN PARTICULAR FOR ROTARY MOTORS IN HOROLOGY

(43) Date de publication de la demande: 26.06.2024
(73) Titulaire: The Swatch Group Research and Development Ltd, 2074 Marin (CH)
(72) Inventeur: KAHROBAIYAN, Mohammad Hussein, 2043 Boudevilliers (CH); FERRI, Yvan, 2024 St-Aubin-Sauges (CH); DIDIER, Alexandre, 3235 Erlach (CH); PARATTE, Lionel, 2074 Marin-Epagnier (CH); BORN, Jean-Jacques, 1110 Morges (CH)
(74) Mandataire: ICB SA

(56) Documents cités:
- EP-A1- 3 182 214
- EP-A1- 3 206 089
- FR-A- 1 562 662

## Description

### Domaine technique de l'invention

L'invention se rapporte au domaine technique des résonateurs piézoélectriques, notamment pour moteurs piézoélectriques rotatifs. L'invention se rapporte également au domaine technique des pièces d'horlogeries munies d'un tel moteur piézoélectrique rotatif.

### Arrière-plan technologique

Les moteurs électriques usuellement utilisés en horlogerie sont des moteurs rotatifs de type « Lavet », qui fonctionnent sur des principes physiques électromagnétiques. Un tel moteur comporte généralement un stator muni de bobines et un rotor aimanté, qui tourne par actionnement déphasé des bobines.

Cependant, ces moteurs ont une résistance limitée aux champs magnétiques élevés. A partir d'une certaine valeur de champs magnétique, le moteur se bloque. En général, ils se bloquent sous l'effet d'un champ magnétique qui dépasse 2 mT.

Ainsi, pour éviter ce problème, il est nécessaire de concevoir des moteurs fonctionnant sur d'autres principes physique.

Il existe par exemple des moteurs électrostatiques à peignes, tel que celui décrit dans le brevet CH709512. Mais les peignes prennent de la place, et ils consomment une énergie plus élevée que les moteurs de type « Lavet ».

Des moteurs basés sur l'effet piézoélectrique ont aussi été mis au point, par exemple dans le brevet EP0587031. Mais celui-ci est limité à l'actionnement d'un quantième. Cependant, sa consommation élevée et le risque d'usure prématurée ne permettent pas l'entraînement d'une aiguille des secondes, qui demande en général le plus d'énergie. Un autre moteur piézoélectrique rotatif résonant, comprenant un actionneur de flexion constitué d'une bilame piézoélectrique pour faire osciller une poutre portant deux masselottes, est connu par le brevet FR 1 562 662.

### Résumé de l'invention

Le but de la présente invention est de proposer un résonateur piézoélectrique, qui peut résister à des champs électromagnétiques élevés, tout en gardant une consommation d'énergie et un volume réduits.

A cet effet, l'invention se rapporte à un résonateur piézoélectrique, notamment pour moteur piézoélectrique rotatif d'une pièce d'horlogerie, le résonateur piézoélectrique comprenant une embase immobile et une masse oscillante s'étendant autour d'un axe longitudinal, la masse oscillante étant munie d'au moins une masselotte, de préférence deux masselottes agencées à des positions opposées.

L'invention est remarquable en ce que le résonateur piézoélectrique comprend un guidage à lames flexibles reliant la masse oscillante à l'embase, de manière à pouvoir faire osciller la masse oscillante autour d'un centre de rotation dans un mouvement de balancier, le guidage flexible comprenant un premier pivot de type RCC muni d'un élément mobile intermédiaire, une première paire de lames - flexibles reliant l'embase à l'élément mobile intermédiaire, et une deuxième paire de lames flexibles formant un deuxième pivot de type RCC reliant l'élément mobile intermédiaire à la masse oscillante, le résonateur piézoélectrique comprenant une première lame flexible reliant l'élément mobile intermédiaire à l'embase, la première lame flexible comportant au moins en partie un matériau piézoélectrique actionnable électriquement pour déformer la première lame flexible et faire osciller la masse oscillante.

Un résonateur ayant une telle configuration permet de fournir un mouvement avec efficacité. En effet, en actionnant le matériau piézoélectrique de la ou des lames flexibles, elles se courbent, de sorte que la masse oscillante oscille en pivotant sur elle-même autour d'un centre de rotation. Ainsi, le résonateur produit un mouvement oscillatoire de la masse oscillante, tout en consommant peu d'énergie, car l'actionnement de la ou des lames flexibles demande moins d'énergie.

En outre, un pivot de type RCC a l'avantage d'augmenter l'amplitude oscillatoire du résonateur, grâce à l'élément mobile intermédiaire et à la deuxième paire de lames flexibles.

Le mouvement oscillatoire peut ainsi être transmis à d'autres pièces mécaniques selon le domaine d'application du résonateur piézoélectrique, par exemple à une roue dentée d'un moteur.

Selon une forme de réalisation particulière de l'invention, la première lame flexible fait partie de la première paire de lames flexibles.

Selon une forme de réalisation particulière de l'invention, le centre de rotation est agencé sensiblement sur l'élément mobile intermédiaire.

Selon une forme de réalisation particulière de l'invention, la première paire de lames flexibles comporte une deuxième lame flexible reliant l'embase à l'élément mobile intermédiaire, la deuxième lame flexible comportant au moins en partie un matériau piézoélectrique actionnable électriquement pour déformer la deuxième lame flexible et faire osciller la masse oscillante.

Selon une forme de réalisation particulière de l'invention, la première lame flexible et la deuxième lame flexible forment un angle compris entre 30° et 150°, de préférence entre 60° et 130°, voire entre 90° et 120°.

Selon une forme de réalisation particulière de l'invention, la première lame flexible et la deuxième lame flexible sont décroisées et s'écartent depuis l'élément mobile intermédiaire jusqu'à des parties excentrées de l'embase.

Selon une forme de réalisation particulière de l'invention, la première lame flexible est une lame supplémentaire différente des lames flexibles de la première paire de lames flexibles.

Selon une forme de réalisation particulière de l'invention, la première paire de lames flexibles comporte une deuxième lame flexible et une troisième lame flexible reliant l'embase à l'élément mobile intermédiaire.

Selon une forme de réalisation particulière de l'invention, la deuxième lame flexible et la troisième lame flexible sont décroisées et s'écartent depuis l'élément mobile intermédiaire jusqu'à des parties excentrées de l'embase.

Selon une forme de réalisation particulière de l'invention, la deuxième lame flexible et la troisième lame flexible forment un angle compris entre 30° et 150°, de préférence entre 60° et 130°, voire entre 90° et 120°.

Selon une forme de réalisation particulière de l'invention, la deuxième paire de lames flexibles comporte deux lames flexibles s'étendant depuis l'élément mobile intermédiaire jusqu'à la masse oscillante.

Selon une forme de réalisation particulière de l'invention, les deux lames flexibles de la deuxième paire de lames flexibles forment un angle compris entre 30° et 150°, de préférence entre 60° et 130°, voire entre 90° et 120°.

Selon une forme de réalisation particulière de l'invention, les deux lames flexibles de la deuxième paire de lames flexibles sont agencées par symétrie axiale l'une par rapport à l'autre.

Selon une forme de réalisation particulière de l'invention, le résonateur est agencé sensiblement dans un même plan.

Selon une forme de réalisation particulière de l'invention, le résonateur est configuré pour faire osciller la masse oscillante à la fréquence propre du résonateur.

Selon une forme de réalisation particulière de l'invention, le résonateur comporte, de préférence majoritairement, un matériau monocristallin ou poly-cristallin amagnétique et de basse conductivité, tels que le silicium, le verre, la céramique, ou un métal, et obtenu par exemple par un procédé photo-lithographique de micro-usinage de type MEMS.

Selon une forme de réalisation particulière de l'invention, le guidage flexible est monobloc.

L'invention se rapporte également à un moteur piézoélectrique, notamment pour un dispositif d'affichage d'une pièce d'horlogerie, comprenant un tel résonateur piézoélectrique.

Selon une forme de réalisation particulière de l'invention, le moteur piézoélectrique comprend au moins un cliquet, de préférence deux cliquets, et une roue mobile, le cliquet étant monté sur la masse oscillante du résonateur piézoélectrique, de manière à faire tourner la roue mobile dans un premier sens, lorsque la masse oscillante effectue ses oscillations.

L'invention se rapporte encore à une pièce d'horlogerie comportant un mouvement d'horlogerie comprenant une transmission d'engrenages configurée pour faire tourner au moins une aiguille, et comprenant un tel moteur piézoélectrique agencé pour actionner la transmission d'engrenages.

### Brève description des figures

D'autres particularités et avantages ressortiront clairement de la description qui en est faite ci-après, à titre indicatif et nullement limitatif, en référence aux dessins annexés, dans lesquels :
- la figure 1 représente schématiquement une vue de dessus d'un premier mode de réalisation d'un résonateur piézoélectrique, notamment pour moteur rotatif, selon l'invention,
- la figure 2 représente schématiquement une vue de dessus d'un deuxième mode de réalisation d'un résonateur piézoélectrique, notamment pour moteur rotatif, selon l'invention,
- la figure 3 représente schématiquement une vue de dessus d'un troisième mode de réalisation d'un résonateur piézoélectrique, notamment pour moteur rotatif, selon l'invention,
- la figure 4 représente schématiquement une vue de dessus d'un quatrième mode de réalisation d'un résonateur piézoélectrique, notamment pour moteur rotatif, selon l'invention, et
- la figure 5 représente schématiquement une vue de dessus d'un mode de réalisation d'un moteur piézoélectrique comprenant résonateur piézoélectrique selon l'invention.

### Description détaillée de l'invention

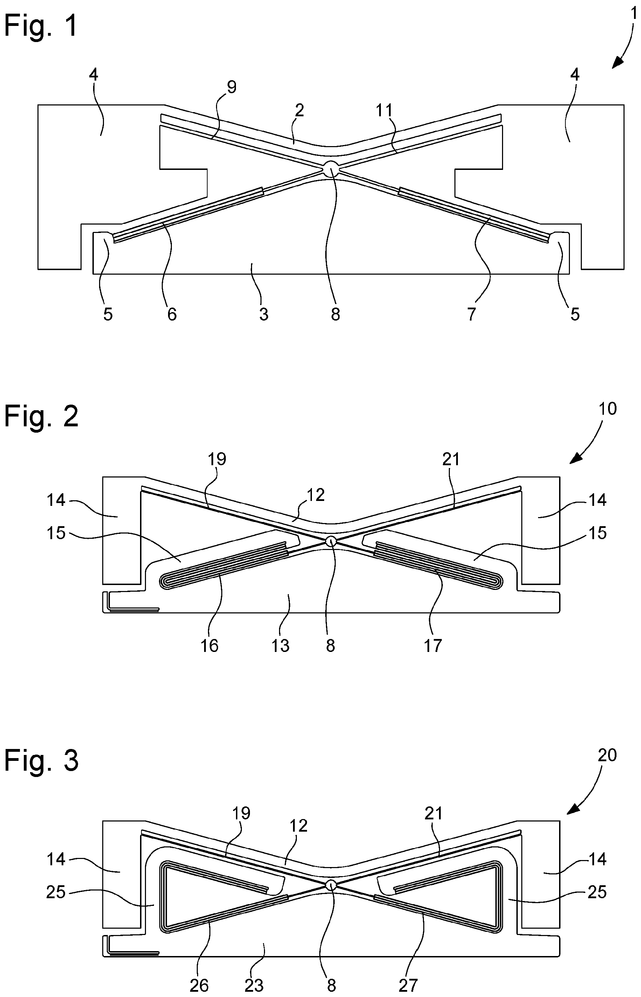

Les figures 1 à 6 montrent des modes de réalisation différents d'un résonateur piézoélectrique, notamment utilisé dans un moteur rotatif. Le moteur peut notamment servir dans une pièce d'horlogerie pour actionner un dispositif d'affichage, comprenant des aiguilles agencées sur un cadran. Le résonateur piézoélectrique 1, 10, 20, 30 s'étend de préférence sensiblement dans un plan.

Sur la figure 1, le premier mode de réalisation de résonateur piézoélectrique comprend une embase 3, qui a ici une forme sensiblement triangulaire, de préférence isocèle.

Le triangle a un sommet principal et deux sommets opposés excentrés. Le triangle a ici deux cotés égaux et une base de longueur supérieure à la hauteur, de préférence au moins deux fois supérieure, voire quatre ou cinq fois supérieure. Les deux sommets opposés comportent chacun une excroissance 5 s'étendant ver le haut du triangle.

Le résonateur 1 comprend en outre une masse oscillante 2. La masse oscillante 2 comprend un bras principal aux extrémités duquel sont agencées deux masselottes 4. Le bras est disposé tangentiellement au sommet principal du triangle. Le bras est sensiblement courbe au milieu pour réserver de la place pour le rotor du moteur. La masse oscillante 2 et l'embase 3 sont agencées de préférence dans un même plan.

Le résonateur comprend un guidage à lames flexibles reliant la masse oscillante 2 à l'embase 3, de manière à pouvoir faire osciller la masse oscillante 2 autour d'un centre de rotation dans un mouvement de balancier.

Selon l'invention, le guidage flexible comprend un premier et un deuxième pivot de type RCC (Remote Center of Compliance). Le premier pivot comprend un élément mobile intermédiaire 8, une première paire de lames flexibles 6, 7 reliant l'embase à l'élément mobile intermédiaire 8. Le deuxième pivot de type RCC comprend une deuxième paire de lames flexibles reliant l'élément mobile intermédiaire à la masse oscillante 2.

L'élément mobile intermédiaire 8 est un élément ponctuel, de petite taille par rapport à l'embase 3 et à la masse oscillante 2. L'élément ponctuel 8 a par exemple une forme cylindrique. De préférence, le centre de rotation est agencé sensiblement au centre de l'élément mobile intermédiaire 8.

La première paire de lames flexibles comprend une première lame flexible 6 reliant l'élément mobile intermédiaire à l'embase 3, et une deuxième lame flexible 7 reliant l'embase 3 à l'élément mobile intermédiaire 8. De préférence, la première lame flexible 6 et la deuxième lame flexible 7 sont sensiblement droites.

La première lame flexible 6 et la deuxième lame flexible 7 sont décroisées et s'écartent depuis l'élément mobile intermédiaire 8 jusqu'à des parties excentrées de l'embase 3, ici les excroissances 5. Ainsi, chaque lame flexible 6, 7 relie une excroissance 5 de l'embase 3 à l'élément mobile intermédiaire 8, en longeant un des côtés égaux du triangle isocèle.

La première lame flexible 6 et la deuxième lame flexible 7 forment un angle compris entre 30° et 150°, de préférence entre 60° et 130°, voire entre 90° et 120°. La première lame flexible 6 et la deuxième lame flexible 7 sont agencées par symétrie axiale l'une par rapport à l'autre.

Dans ce mode de réalisation, la première lame flexible 6 fait partie de la première paire de lames flexibles du premier pivot de type RCC.

La deuxième paire de lames flexibles comporte une troisième lame flexible 9, et une quatrième lames flexible 11 s'étendant depuis l'élément mobile intermédiaire jusqu'à la masse oscillante 2, plus particulièrement en haut des masselottes 4, juste en-dessous du bras.

Ainsi, les lames de la première paire de lames flexibles et de la deuxième paire de lames flexibles s'étendent d'un côté opposé aux lames de la première paire.

De préférence, la première lame flexible 6 et la quatrième lame flexible 11 sont symétriques par rapport à l'élément intermédiaire 8. De préférence, la deuxième lame flexible 7 et la une troisième lame flexible 9 sont symétriques par rapport à l'élément intermédiaire 8.

La première lame flexible 6 et la troisième lame flexible 9 forment un angle compris entre 40° et 90°. La deuxième lame flexible 7 et la quatrième lame flexible 11 forment de préférence un angle identique.

La première lame flexible 6 et la deuxième lame flexible 7 comportent au moins en partie un matériau piézoélectrique actionnable électriquement pour les déformer et faire osciller la masse oscillante 2.

Dans ce mode de réalisation, le matériau piézoélectrique piézoélectriques est agencé sur une partie seulement de chaque lame flexible 6, 7.

Les lames flexibles ont par exemple une couche de matériau piézoélectrique prise en sandwich entre deux couches d'électrodes. Les couches d'électrodes sont elles-mêmes agencées au-dessus d'un matériau structurel de support monolithique, par exemple du silicium monocristallin ou polycristallin, tel que du quartz, du verre, du métal, etc...

Pour actionner les lames flexibles 6, 7, les excroissances 5 comprennent plusieurs contacts électriques reliés aux couches d'électrodes pour recevoir une tension électrique et actionner les couches piézoélectriques des lames flexibles.

Les couches piézoélectriques comportent de préférence un matériau cristallin ou polycristallin, par exemple en céramique solide (pour niobate de Potassium sodium) ou de type PZT (pour titano-zirconates de plomb, les lames flexibles 6, 7 ayant une épaisseur leur permettant de se déformer.

Ainsi, en activant électriquement les couches de matériau piézoélectrique, les lames flexibles 6, 7 se déforment alternativement latéralement en direction du centre et de l'extérieur. L'activation est produite avec une tension alternative.

En choisissant un actionnement les deux lames flexibles 6, 7 en opposition de phase, par inversion de polarité d'une lame à l'autre, l'élément intermédiaire 8 effectue de petites oscillations, qui sont transmises à la masse oscillante 2 par l'intermédiaire des lames flexibles 9, 11 de la deuxième paire.

Ainsi, la masse oscillante 2 oscille autour d'un centre de rotation correspondant au point de croisement des deux lames flexibles, ici au niveau de l'élément intermédiaire 8. Les deux masselottes 4 se déplacent latéralement à une certaine fréquence, de préférence à la fréquence de résonance du résonateur.

Un guidage flexible à double pivot de type RCC permet d'augmenter l'amplitude d'oscillation de la masse oscillante 2, grâce à la deuxième paire de lames flexibles 9, 11.

Dans le deuxième mode réalisation de résonateur 10 de la figure 2, l'embase 13 comprend des excroissance 15 rigides formant un bras allongé longeant chaque côté du triangle, de manière à former deux canaux ouverts dans l'embase. La première lame flexible 16 et la deuxième lame flexible 17 ont une forme en U dans chaque canal. Chaque lame flexible 16, 17 est rattachée au bras à l'entrée du canal.

Cette configuration permet d'agencer des lames flexibles plus longues, pour augmenter l'amplitude des oscillations.

Le reste du résonateur 10 est sensiblement identique au premier mode de réalisation.

Le troisième mode de réalisation d'un résonateur 20 piézoélectrique de la figure 3, montre est une variante du deuxième mode de réalisation.

Pour augmenter davantage la longueur des lames flexibles de la première paire, les excroissances 25 rigides de l'embase 23 forment un bras coudé s'étendant depuis le triangle de l'embase 23 vers la masse oscillante 12, puis vers l'élément intermédiaire 8 après le coude.

La première lame flexible 26 et la deuxième lame flexible 27 longent chacune un côté du triangle de l'embase 23, puis le bras coudé de l'excroissance, pour être rattachée à l'extrémité du bras coudé.

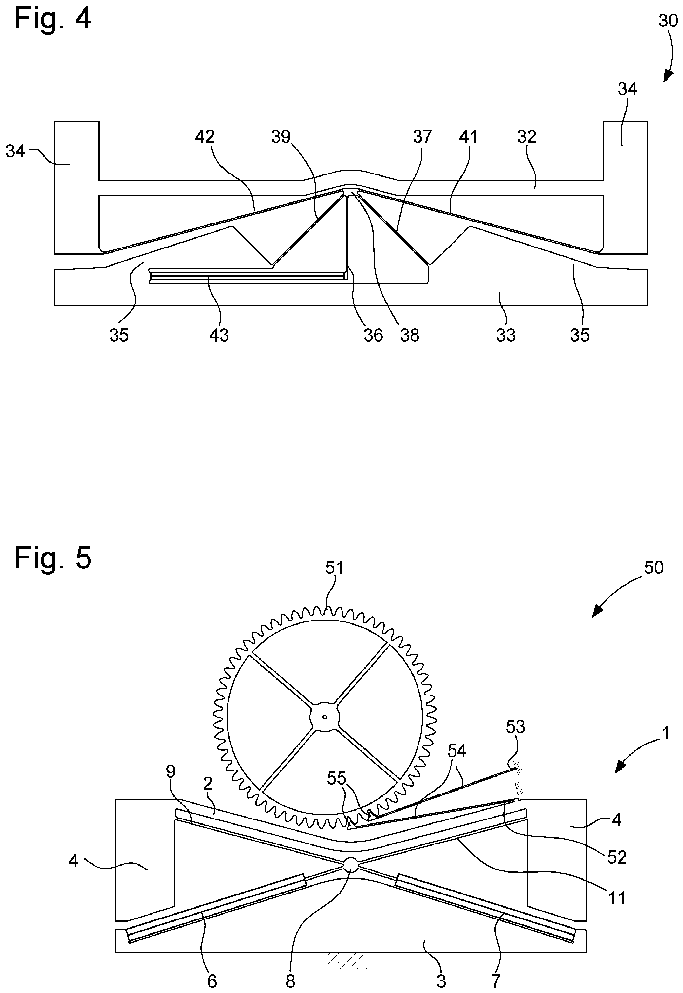

Le quatrième mode de réalisation de la figure 4 comprend un guidage flexible à double pivot RCC comportant un élément intermédiaire 38, une première paire de lames flexibles et une deuxième paire de lames flexibles sans matériau piézoélectrique.

L'embase 33 a une forme évidée au centre et deux excroissances sensiblement triangulaires de chaque côté du centre évidé.

Pour actionner le guidage flexible, le résonateur comprend une première lame flexible 36 agencée entre les lames flexibles 37, 39 de la première paire de lames flexibles. La première lame flexible 36 a une forme en L, dont le premier segment 43, qui est relié à un triangle de l'embase 33, comprend le matériau piézoélectrique, et le deuxième segment 44 du L est relié à l'élément intermédiaire 38.

La première lame flexible 36 est une lame supplémentaire différente des lames flexibles de la première et de la deuxième paire de lames flexibles, et qui sert particulièrement à l'actionnement du guidage flexible.

La première paire comprend une deuxième lame flexible 37 et une troisième lame flexible 39 relient chacune une excroissance 35 à l'élément intermédiaire 38. La deuxième lame flexible 37 et la troisième lame flexible 39 sont décroisées et s'écartent depuis l'élément mobile intermédiaire 38 jusqu'à l'embase 33. La deuxième lame flexible 37 et la troisième lame flexible 39 sont de préférence agencées par symétrie axiale l'une par rapport à l'autre.

La deuxième paire comprend une quatrième lame flexible 41 et une cinquième lame flexible 42. La quatrième lame flexible 41 et la cinquième lame flexible 42 relient chacune l'élément intermédiaire 38 la masse oscillante 32, en particulier à une masselotte 34 de la masse oscillante 32. La quatrième lame flexible 41 et la cinquième lame flexible 42 sont décroisées et s'écartent depuis l'élément mobile intermédiaire 38 jusqu'à la masse oscillante 32. La quatrième lame flexible 41 et la cinquième lame flexible 42 sont de préférence agencées par symétrie axiale l'une par rapport à l'autre.

Les lames de la première paire et de la deuxième paire s'étendent d'un même côté en direction de l'embase 33.

A cette fin, la quatrième lame flexible 41 et la cinquième lame flexible 42 sont reliées à l'extrémité libre des masselottes 34 de la masse oscillante 32 devant l'embase 33.

Les lames 37, 39 de la première paire de lames flexibles s'étendent en partie entre les lames 41, 42 de la deuxième paire de lames flexibles.

La quatrième lame flexible 41 et la cinquième lame flexible 42 forment un angle compris entre 90° et 160°.

La deuxième lame flexible 37 et la troisième lame flexible 39 forment un angle compris entre 60° et 100°.

Grâce au matériau piézoélectrique de la première lame flexible 36, on déforme alternativement la première lame flexible 36 pour provoquer l'oscillation de l'élément intermédiaire 38, qui est transmise à la masse oscillante 32.

Les résonateurs 1, 10, 20, 30 selon les modes de réalisation décrits précédemment, comportent, de préférence majoritairement, un matériau mono- cristallin ou poly-cristallin, tels que le silicium, le verre, la céramique, ou un métal.

Les résonateurs 1, 10, 20, 30 sont par exemple obtenus par des procédés photo-lithographiques de micro-usinage de type MEMS (pour micro-electro mechanical systems), Les qualités de rigidité, d'élasticité et la précision d'usinage de tels matériaux confèrent une grande qualité de résonance aux résonateurs 1, 10, 20, 30.

De plus, les caractéristiques d'amagnétisme et de basse conductivité de certains de ces matériaux permettent d'obtenir une excellente résistance aux champs magnétiques continus et alternatifs de valeurs élevées.

En outre, les résonateurs 1, 10, 20, 30 sont configurés pour faire osciller la masse oscillante 2, 12, 32, 42 à la fréquence propre du résonateur 1, 10, 20, 30. Ainsi, on limite la consommation d'énergie du résonateur, notamment en augmentant la course angulaire de la masse oscillante.

La figure 5 montre un mode de réalisation d'un moteur piézoélectrique 50 rotatif, notamment pour un dispositif d'affichage d'une pièce d'horlogerie.

Le moteur piézoélectrique 50 peut notamment servir dans une pièce d'horlogerie pour actionner un dispositif d'affichage, comme des aiguilles agencées sur un cadran. Le moteur piézoélectrique 50 est configuré pour pouvoir tourner et actionner une transmission d'engrenages mécanique du dispositif d'affichage.

Le moteur piézoélectrique 50 comprend un résonateur piézoélectrique selon l'invention, ici le résonateur piézoélectrique 1 du premier mode de réalisation de la figure 1. Les autres modes de réalisation de résonateur piézoélectrique peuvent également être utilisés sans que cela change le fonctionnement du moteur piézoélectrique 50. Le résonateur piézoélectrique 1 est assemblé à une platine par son embase 3.

Le moteur piézoélectrique 50 comprend en outre une roue mobile 51 dentée et deux cliquets 52, 53 configurés pour faire tourner la roue mobile 51 dans un seul sens. La roue mobile 51 comprend une denture périphérique, de préférence asymétrique, qui définit le sens de rotation. La roue mobile 50 est reliée à un rouage muni d'aiguilles du dispositif d'affichage.

Le premier cliquet 52 a pour fonction de faire tourner la roue mobile 51 dans un premier sens, par exemple antihoraire, tandis que le deuxième cliquet 53 retient la roue mobile 51 lorsque le premier cliquet 52 se réarme sur la dent suivante du rotor 51.

Chaque cliquet 52, 53 comporte une lame flexible 54 munie d'une dent 55, de préférence asymétrique, à son extrémité.

La rotation de la roue mobile 51 est engendrée grâce au déplacement du premier cliquet 52. Le premier cliquet 52 est monté sur la masse oscillante 2 du résonateur piézoélectrique 1. Ainsi, lorsque le résonateur oscille, le premier cliquet 52 oscille également, de sorte qu'il pousse ou tire la roue mobile 51 dentée dans un premier sens selon le positionnement du résonateur piézoélectrique par rapport à la roue mobile 51.

Le deuxième cliquet 53 est soit assemblé sur la platine, un pont de platine, ou directement sur l'embase 3 pour limiter l'erreur de positionnent dû à l'enchaînement des tolérances d'assemblage. Il a pour fonction d'empêcher la roue dentée de tourner dans le sens opposé du premier sens. La dent 55 du deuxième cliquet 53 est configurée pour coopérer avec la denture asymétrique, de manière à laisser la roue mobile 51 tourner dans le premier sens, et à la bloquer dans le sens opposé.

A cette fin, les bras flexible 54 des cliquets 52, 53 sont en position droite relâchée, lorsque la dent 55 est insérée dans la denture de la roue dentée 51, tandis qu'il est armé et courbé, lorsqu'il est repoussé vers l'extérieur par la denture, quand la roue dentée 51 tourne dans le premier sens.

Dans le cas d'une montre, la fréquence de résonance ou fréquence propre du moteur 50 est adaptée à la fréquence du quartz, lequel sert à régler la marche du mouvement. On choisit une fréquence d'excitation correspondant à un sous-multiple de la fréquence du quartz, qui est généralement de 32764 Hz. Par exemple, on choisit une fréquence de 128Hz ou 256 Hz. La fréquence du moteur 50 est de préférence ajustée et accordée à la fréquence d'excitation de sorte que son amplitude d'oscillation ne descende pas en-dessous de 90-95% de l'amplitude maximale.

De manière optionnelle, le deuxième cliquet 53 peut être configuré pour servir de capteur de pas, afin de déterminer la distance ou la vitesse de rotation de la roue mobile 51. A cette fin, le bras flexible 54 du deuxième cliquet 53 est doté d'un matériau piézoélectrique relié à une unité de comptage. Ainsi, à chaque courbure du deuxième cliquet 53, l'unité de comptage enregistre une rotation de la roue mobile 51 d'une dent.

On comprendra que diverses modifications et/ou améliorations et/ou combinaisons évidentes pour l'homme du métier peuvent être apportées aux différentes formes d'exécution de l'invention exposée ci-dessus sans sortir du cadre de l'invention définie par les revendications annexées.

## Revendications

1. Résonateur piézoélectrique (1, 10, 20, 30), notamment pour un moteur piézoélectrique rotatif, le résonateur (1, 10, 20, 30) comprenant une embase (3, 13, 23, 33) immobile, une masse oscillante (2, 12, 32) étant munie d'au moins une masselotte (4, 14, 34), de préférence deux masselottes (4, 14, 34) agencées à des positions opposées, et un guidage à lames flexibles reliant la masse oscillante (2, 12, 32) à l'embase (3, 13, 23, 33), de manière à pouvoir faire osciller la masse oscillante (2, 12, 32) autour d'un centre de rotation dans un mouvement de balancier, **caractérisé en ce que** le guidage flexible comprend un premier pivot de type RCC, pour « Remote Center of Compliance » en anglais, muni d'un élément mobile intermédiaire (8, 38) et d'une première paire de lames flexibles (6, 7, 16, 17, 26, 27, 37, 39) reliant l'embase (3, 13, 23, 33) à l'élément mobile intermédiaire (8, 38), et une deuxième paire de lames flexibles (9, 11, 19, 21, 41, 42) formant un deuxième pivot de type RCC reliant l'élément mobile intermédiaire (8, 38) à la masse oscillante (2, 12, 32), le résonateur piézoélectrique (1, 10, 20, 30) comprenant une première lame flexible (6, 16, 26, 36) reliant l'élément mobile intermédiaire (8, 38) à l'embase (3, 13, 23, 33), la première lame flexible (6, 16, 26, 36) comportant au moins en partie un matériau piézoélectrique actionnable électriquement pour déformer la première lame flexible (6, 16, 26, 36) et faire osciller la masse oscillante (2, 12, 32).

2. Résonateur piézoélectrique selon la revendication 1, dans lequel le centre de rotation est agencé sensiblement au centre de l'élément mobile intermédiaire (8, 38).

3. Résonateur piézoélectrique selon la revendication 1 ou 2, dans lequel la première lame flexible (6, 16, 26, 36) fait partie de la première paire de lames flexibles.

4. Résonateur piézoélectrique selon la revendication 3, dans lequel la première paire de lames flexibles comporte une deuxième lame flexible (7, 17, 27) reliant l'embase (3, 13, 23) à l'élément mobile intermédiaire (8, 38), la deuxième lame flexible (7, 17, 27) comportant au moins en partie un matériau piézoélectrique actionnable électriquement pour déformer la deuxième lame flexible (7, 17, 27) et faire osciller la masse oscillante (2, 12).

5. Résonateur piézoélectrique selon la revendication 4, dans lequel la première lame flexible (6, 16, 26) et la deuxième lame flexible (7, 17, 27) forment un angle compris entre 30° et 150°, de préférence entre 60° et 130°, voire entre 90° et 120°.

6. Résonateur piézoélectrique selon la revendication 5, dans lequel la première lame flexible (6, 16, 26) et la deuxième lame flexible (7, 17, 27) sont décroisées et s'écartent depuis l'élément mobile intermédiaire (8) jusqu'à des parties excentrées de l'embase (3, 13).

7. Résonateur piézoélectrique selon la revendication 3, dans lequel la première lame flexible (36) est une lame supplémentaire différente des lames flexibles (37, 39) de la première paire de lames flexibles.

8. Résonateur piézoélectrique selon la revendication 7, dans lequel la première paire de lames flexibles comporte une deuxième lame flexible (37) et une troisième lame flexible (39) reliant l'embase (33) à l'élément mobile intermédiaire (38).

9. Résonateur piézoélectrique selon la revendication 8, dans lequel la deuxième lame flexible (37) et la troisième lame flexible (39) sont décroisées et s'écartent depuis l'élément mobile intermédiaire (38) jusqu'à des parties excentrées de l'embase (33).

10. Résonateur piézoélectrique selon la revendication 8 ou 9, dans lequel la deuxième lame flexible (37) et la troisième lame flexible (39) forment un angle compris entre 30° et 150°, de préférence entre 60° et 130°, voire entre 90° et 120°.

11. Résonateur piézoélectrique selon l'une, quelconque, des revendications précédentes, dans lequel la deuxième paire de lames flexibles comporte deux lames flexibles (9, 11, 19, 21, 41, 42) s'étendant depuis l'élément mobile intermédiaire (8, 38) jusqu'à la masse oscillante (2, 12, 32).

12. Résonateur piézoélectrique selon la revendication 11, dans lequel les deux lames flexibles (9, 11, 19, 21, 41, 42) de la deuxième paire de lames flexibles forment un angle compris entre 30° et 150°, de préférence entre 60° et 130°, voire entre 90° et 120°.

13. Résonateur piézoélectrique selon la revendication 12, dans lequel les deux lames flexibles (9, 11, 19, 21, 41, 42) de la deuxième paire de lames flexibles sont agencées par symétrie axiale l'une par rapport à l'autre.

14. Résonateur piézoélectrique selon l'une, quelconque, des revendications précédentes, **caractérisé en ce qu'**il est agencé sensiblement dans un même plan.

15. Résonateur piézoélectrique selon l'une, quelconque, des revendications précédentes, **caractérisé en ce qu'**il est configuré pour faire osciller la masse oscillante (2, 12, 32) à la fréquence propre du résonateur (1, 10, 20, 30).

16. Résonateur selon l'une, quelconque, des revendications précédentes, comportant, de préférence majoritairement, un matériau monocristallin ou poly-cristallin amagnétique et de basse conductivité, tels que le silicium, le verre, la céramique, ou un métal, et obtenu par exemple par un procédé photo-lithographique de micro-usinage de type MEMS.

17. Moteur piézoélectrique (50), notamment pour un dispositif d'affichage d'une pièce d'horlogerie, comprenant un résonateur piézoélectrique (1, 10, 20, 30) selon l'une, quelconque, des revendications précédentes.

18. Moteur piézoélectrique (50) selon la revendication 17, comprenant au moins un cliquet (52), de préférence deux cliquets (52, 53), et une roue mobile (51), le cliquet (52) étant monté sur la masse oscillante (2) du résonateur piézoélectrique (1), de manière à faire tourner la roue mobile (51) dans un premier sens, lorsque la masse oscillante (2) effectue ses oscillations.

19. Pièce d'horlogerie comportant un mouvement d'horlogerie comprenant une transmission d'engrenages configurée pour faire tourner au moins une aiguille, **caractérisé en ce qu'**elle comprend un résonateur piézoélectrique (1, 10, 20, 30) ou un moteur piézoélectrique (50) selon l'une, quelconque, des revendications précédentes, le moteur piézoélectrique (50) étant agencé pour actionner la transmission d'engrenages.

## Patentansprüche

1. Piezoelektrischer Resonator (1, 10, 20, 30), insbesondere für einen rotatorischen piezoelektrischen Motor, umfassend eine feste Basis (3, 13, 23, 33), eine Schwingmasse (2, 12, 32), die mit mindestens einem Trägheitsgewicht (4, 14, 34), vorzugsweise mit zwei Trägheitsgewichten (4, 14, 34), versehen ist, die an gegenüberliegenden Positionen angeordnet sind, sowie eine Lamellenführung mit flexiblen Lamellen, die die Schwingmasse (2, 12, 32) mit der Basis (3, 13, 23, 33) verbindet, so dass die Schwingmasse (2, 12, 32) um ein Schwingzentrum in einer Pendelbewegung oszillieren kann, **dadurch gekennzeichnet, dass** die Lamellenführung ein erstes RCC-Gelenk (_{"}Remote Center of Compliance") umfasst, versehen mit einem beweglichen Zwischenelement (8, 38) und einem ersten Paar flexibler Lamellen (6, 7, 16, 26, 27, 37, 39), das die Basis (3, 13, 23, 33) mit dem beweglichen Zwischenelement (8, 38) verbindet, sowie ein zweites Paar flexibler Lamellen (9, 11, 19, 21, 41, 42), das ein zweites RCC-Gelenk bildet und das bewegliche Zwischenelement (8, 38) mit der Schwingmasse (2, 12, 32) verbindet, wobei der piezoelektrische Resonator (1, 10, 20, 30) eine erste flexible Lamelle (6, 16, 26, 36) umfasst, die das bewegliche Zwischenelement (8, 38) mit der Basis (3, 13, 23, 33) verbindet, wobei diese erste flexible Lamelle (6, 16, 26, 36) zumindest abschnittsweise aus einem piezoelektrischen, elektrisch ansteuerbaren Material besteht, um die erste flexible Lamelle (6, 16, 26, 36) zu verformen und dadurch die Schwingmasse (2, 12, 32) in Schwingung zu versetzen.

2. Piezoelektrischer Resonator nach Anspruch 1, **dadurch gekennzeichnet, dass** das Schwingzentrum im Wesentlichen im Zentrum des beweglichen Zwischenelements (8, 38) angeordnet ist.

3. Piezoelektrischer Resonator nach Anspruch 1 oder 2, **dadurch gekennzeichnet, dass** die erste flexible Lamelle (6, 16, 26, 36) Teil des ersten Paars flexibler Lamellen ist.

4. Piezoelektrischer Resonator nach Anspruch 3, **dadurch gekennzeichnet, dass** das erste Paar flexibler Lamellen eine zweite flexible Lamelle (7, 17, 27) umfasst, welche die Basis (3, 13, 23) mit dem beweglichen Zwischenelement (8, 38) verbindet, wobei die zweite flexible Lamelle (7, 17, 27) zumindest abschnittsweise aus einem piezoelektrischen, elektrisch ansteuerbaren Material besteht, um die zweite flexible Lamelle (7, 17, 27) zu verformen und dadurch die Schwingmasse (2, 12) in Schwingung zu versetzen.

5. Piezoelektrischer Resonator nach Anspruch 4, **dadurch gekennzeichnet, dass** die erste flexible Lamelle (6, 16, 26) und die zweite flexible Lamelle (7, 17, 27) einen Winkel zwischen 30° und 150°, vorzugsweise zwischen 60° und 130°, insbesondere zwischen 90° und 120°, einschließen.

6. Piezoelektrischer Resonator nach Anspruch 5, **dadurch gekennzeichnet, dass** die erste flexible Lamelle (6, 16, 26) und die zweite flexible Lamelle (7, 17, 27) ungekreuzt angeordnet sind und sich vom beweglichen Zwischenelement (8) zu exzentrisch angeordneten Bereichen der Basis (3, 13) erstrecken.

7. Piezoelektrischer Resonator nach Anspruch 3, **dadurch gekennzeichnet, dass** die erste flexible Lamelle (36) eine zusätzliche Lamelle ist, die sich von den flexiblen Lamellen (37, 39) des ersten Paars flexibler Lamellen unterscheidet.

8. Piezoelektrischer Resonator nach Anspruch 7, **dadurch gekennzeichnet, dass** das erste Paar flexibler Lamellen eine zweite flexible Lamelle (37) und eine dritte flexible Lamelle (39) umfasst, welche die Basis (33) mit dem beweglichen Zwischenelement (38) verbinden.

9. Piezoelektrischer Resonator nach Anspruch 8, **dadurch gekennzeichnet, dass** die zweite flexible Lamelle (37) und die dritte flexible Lamelle (39) ungekreuzt angeordnet sind und sich vom beweglichen Zwischenelement (38) zu exzentrisch angeordneten Bereichen der Basis (33) erstrecken.

10. Piezoelektrischer Resonator nach Anspruch 8 oder 9, **dadurch gekennzeichnet, dass** die zweite flexible Lamelle (37) und die dritte flexible Lamelle (39) einen Winkel zwischen 30° und 150°, vorzugsweise zwischen 60° und 130°, insbesondere zwischen 90° und 120°, einschließen.

11. Piezoelektrischer Resonator nach einem der vorhergehenden Ansprüche, **dadurch gekennzeichnet, dass** das zweite Paar flexibler Lamellen zwei flexible Lamellen (9, 11, 19, 21, 41, 42) umfasst, die sich vom beweglichen Zwischenelement (8, 38) zur Schwingmasse (2, 12, 32) erstrecken.

12. Piezoelektrischer Resonator nach Anspruch 11, **dadurch gekennzeichnet, dass** die beiden flexiblen Lamellen (9, 11, 19, 21, 41, 42) des zweiten Paars flexibler Lamellen einen Winkel zwischen 30° und 150°, vorzugsweise zwischen 60° und 130°, insbesondere zwischen 90° und 120°, einschließen.

13. Piezoelektrischer Resonator nach Anspruch 12, **dadurch gekennzeichnet, dass** die beiden flexiblen Lamellen (9, 11, 19, 21, 41, 42) des zweiten Paars flexibler Lamellen axialsymmetrisch zueinander angeordnet sind.

14. Piezoelektrischer Resonator nach einem der vorhergehenden Ansprüche, **dadurch gekennzeichnet, dass** er im Wesentlichen in einer gemeinsamen Ebene angeordnet ist.

15. Piezoelektrischer Resonator nach einem der vorhergehenden Ansprüche, **dadurch gekennzeichnet, dass** er so ausgebildet ist, die Schwingmasse (2, 12, 32) mit der Eigenfrequenz des Resonators (1, 10, 20, 30) in Schwingung zu versetzen.

16. Resonator nach einem der vorhergehenden Ansprüche, **dadurch gekennzeichnet, dass** er vorzugsweise überwiegend aus einem einkristallinen oder polykristallinen, amagnetischen und elektrisch schwach leitfähigen Material besteht, wie Silizium, Glas, Keramik oder einem Metall, und beispielsweise durch ein photolithographisches Mikrobearbeitungsverfahren vom Typ MEMS hergestellt ist.

17. Piezoelektrischer Motor (50), insbesondere für eine Anzeigevorrichtung einer Uhr, umfassend einen piezoelektrischen Resonator (1, 10, 20, 30) nach einem der vorhergehenden Ansprüche.

18. Piezoelektrischer Motor (50) nach Anspruch 17, **dadurch gekennzeichnet, dass** er mindestens einen Klinkenhebel (52), vorzugsweise zwei Klinkenhebel (52, 53), und ein bewegliches Rad (51) umfasst, wobei der Klinkenhebel (52) an der Schwingmasse (2) des piezoelektrischen Resonators (1) angebracht ist, um das bewegliche Rad (51) bei den Schwingungen der Schwingmasse (2) in einer ersten Drehrichtung anzutreiben.

19. Uhr mit einem Uhrwerk, das ein Räderwerk umfasst, welches zum Antreiben von mindestens einem Zeiger ausgebildet ist, **dadurch gekennzeichnet, dass** sie einen piezoelektrischen Resonator (1, 10, 20, 30) oder einen piezoelektrischen Motor (50) nach einem der vorhergehenden Ansprüche umfasst, wobei der piezoelektrische Motor (50) zum Antreiben des Räderwerks ausgebildet ist.

## Claims

1. A piezoelectric resonator (1, 10, 20, 30), in particular for a rotary piezoelectric motor, the resonator (1, 10, 20, 30) comprising a stationary base (3, 13, 23, 33), an oscillating mass (2, 12, 32) being provided with at least one inertia-block (4, 14, 34), preferably two inertia-blocks (4, 14, 34) arranged in opposite positions, and a flexible blade guide connecting the oscillating mass (2, 12, 32) to the base (3, 13, 23, 33), so as to be able to cause the oscillating mass (2, 12, 32) to oscillate about a centre of rotation in a balance movement, **characterised in that** the flexible guide comprises a first RCC-type pivot, for "Remote Center of Compliance" provided with an intermediate moving element (8, 38) and a first pair of flexible blades (6, 7, 16, 17, 26, 27, 37, 39) connecting the base (3, 13, 23, 33) to the intermediate moving element (8, 38), and a second pair of flexible blades (9, 11, 19, 21, 41, 42) forming a second RCC-type pivot connecting the intermediate moving element (8, 38) to the oscillating mass (2, 12, 32), the piezoelectric resonator (1, 10, 20, 30) comprising a first flexible blade (6, 16, 26, 36) connecting the intermediate moving element (8, 38) to the base (3, 13, 23, 33), the first flexible blade (6, 16, 26, 36) including at least in part a piezoelectric material that can be electrically actuated to deform the first flexible blade (6, 16, 26, 36) and cause the oscillating mass (2, 12, 32) to oscillate.

2. The piezoelectric resonator according to claim 1, wherein the centre of rotation is arranged substantially at the centre of the intermediate moving element (8, 38).

3. The piezoelectric resonator according to claim 1 or 2, wherein the first flexible blade (6, 16, 26, 36) is one of the first pair of flexible blades.

4. The piezoelectric resonator according to claim 3, wherein the first pair of flexible blades includes a second flexible blade (7, 17, 27) connecting the base (3, 13, 23) to the intermediate moving element (8, 38), the second flexible blade (7, 17, 27) including at least in part a piezoelectric material that can be electrically actuated to deform the second flexible blade (7, 17, 27) and cause the oscillating mass (2, 12) to oscillate.

5. The piezoelectric resonator according to claim 4, wherein the first flexible blade (6, 16, 26) and the second flexible blade (7, 17, 27) form an angle comprised between 30° and 150°, preferably between 60° and 130°, or even between 90° and 120°.

6. The piezoelectric resonator according to claim 5, wherein the first flexible blade (6, 16, 26) and the second flexible blade (7, 17, 27) are uncrossed and extend from the intermediate moving element (8) to eccentric portions of the base (3, 13).

7. The piezoelectric resonator according to claim 3, wherein the first flexible blade (36) is an additional blade different from the flexible blades (37, 39) of the first pair of flexible blades.

8. The piezoelectric resonator according to claim 7, wherein the first pair of flexible blades includes a second flexible blade (37) and a third flexible blade (39) connecting the base (33) to the intermediate moving element (38).

9. The piezoelectric resonator according to claim 8, wherein the second flexible blade (37) and the third flexible blade (39) are uncrossed and extend from the intermediate moving element (38) to eccentric portions of the base (33).

10. The piezoelectric resonator according to claim 8 or 9, wherein the second flexible blade (37) and the third flexible blade (39) form an angle comprised between 30° and 150°, preferably between 60° and 130°, or even between 90° and 120°.

11. The piezoelectric resonator according to any one of the preceding claims, wherein the second pair of flexible blades includes two flexible blades (9, 11, 19, 21, 41, 42) extending from the intermediate moving element (8, 38) to the oscillating mass (2, 12, 32).

12. The piezoelectric resonator according to claim 11, wherein the two flexible blades (9, 11, 19, 21, 41, 42) of the second pair of flexible blades form an angle comprised between 30° and 150°, preferably between 60° and 130°, or even between 90° and 120°.

13. The piezoelectric resonator according to claim 12, wherein the two flexible blades (9, 11, 19, 21, 41, 42) of the second pair of flexible blades are arranged axially symmetrically with respect to each other.

14. The piezoelectric resonator according to any one of the preceding claims, **characterised in that** it is arranged substantially in the same plane.

15. The piezoelectric resonator according to any one of the preceding claims, **characterised in that** it is configured to cause the oscillating mass (2, 12, 32) to oscillate at the natural frequency of the resonator (1, 10, 20, 30).

16. The resonator according to any one of the preceding claims, preferably including, preferably mainly, a non-magnetic monocrystalline or polycrystalline material with low conductivity, such as silicon, glass, ceramic or a metal, and obtained, for example, by a MEMS-type photolithographic micromachining method.

17. A piezoelectric motor (50), in particular for a display device of a timepiece, comprising a piezoelectric resonator (1, 10, 20, 30) according to any one of the preceding claims.

18. The piezoelectric (50)motor according to claim 17, comprising at least one pawl (52), preferably two pawls (52, 53), and a moving wheel (51), the pawl (52) being mounted on the oscillating mass (2) of the piezoelectric resonator (1) so as to rotate the moving wheel (51) in a first direction when the oscillating mass (2) performs its oscillations.

19. A timepiece including a horological movement comprising a gear transmission configured to rotate at least one hand, **characterised in that** it comprises a piezoelectric resonator (1, 10, 20, 30) or a piezoelectric motor (50) according to any one of the preceding claims, the piezoelectric motor (50) being arranged to actuate the gear transmission.
